# EUROPEAN PATENT APPLICATION

(11) **EP 1 895 609 A2**
(43) Date of publication of application: **05.03.2008**
(21) Application number: 07114632.8
(22) Date of filing: 20.08.2007
(51) Int. Cl.: H01L 51/52

(54) **Method for hermetically sealing an OLED display**

(30) Priority: 24.08.2006 US 509447
(71) Applicant: Corning Incorporated, Corning, NY 14831 (US)
(72) Inventor: Logunov, Stephan Lvovich, Corning, NY 14830 (US); Reddy, Kamjula Pattabhirami, Corning, NY 14830 (US); Vaddi, Butchi Reddy, Painted Post, NY 14870 (US)
(74) Representative: Marchant, James Ian

(57) **Abstract**

A top emission, organic light emitting diode display comprises an organic light emitting diode (OLED), a first substrate having an inner surface, and a second substrate having an inner surface, wherein the OLED is sandwiched between the first substrate and the second substrate. At least one of the first substrate and the second substrate includes a pocket formed in the inner surface thereof having a depth such that a distance between the inner surface of the first substrate and the inner surface of the second substrate sufficient to reduce or eliminate the formation of optical distortions such as Newton rings in the display. Other embodiments of the display comprise a frit located between the first and second substrates having a thickness such that the distance between the inner surfaces of the first and second substrates is great enough to prevent the formation of Newton rings.

## Description

### BACKGROUND OF THE INVENTION

### Field of the Invention

The present invention relates to hermetically sealed glass packages that are suitable to protect thin film devices that are sensitive to ambient environment, and more particularly relates to glass packages suitable for use with top emission, organic light-emitting diodes and the elimination of Newton rings resultant from inadequate spacing of glass substrates within the glass package.

### Description of Related Art

Organic light-emitting diodes (OLED) have been the subject of a considerable amount of research in recent years due to the potential use in a wide variety of electroluminescent devices. For example, a single OLED can be used in a discreet light-emitting device or an array of OLEDs can be used in lighting applications or flat-panel display applications. Traditional OLED displays are relatively bright and have a good color contrast and wide viewing angle. The traditional OLED, display and in particular the electrodes and organic layers located therein, are susceptible to degradation resulting from interaction with oxygen and moisture leaking into the OLED display from the ambient environment. It is well known that the life of the OLED display can be significantly increased if the electrodes and organic layers within the OLED display are hermetically sealed from the ambient environment. Heretofore, it has been difficult to develop a sealing process to hermetically seal an OLED display. Numerous factors that contribute to the difficulty and properly sealing an OLED display include providing a hermetic seal that provides a proper barrier, i.e., limiting oxygen permeation to 10⁻³ cc/m²/day and water permeation to 10⁻⁶ g/m²/day, minimizing the overall size of the hermetic seal so that the hermetic seal does not have an adverse effect on the display area of the associated OLED display, and limiting the temperature generated during the sealing process so as to prevent damage to the materials of the OLED. For instance, in many applications the first pixels of OLEDs are located approximately 1-2 mm from the seal location and should not be heated to a temperature of greater than 100°C during the sealing process. Other limiting factors include minimizing the gases released during the sealing process so as to not contaminate the materials within the OLED display, and enabling electrical connections to enter the OLED display, e.g., thin-film chromium.

Previous sealing methods employed in OLED displays have included the use of epoxies, inorganic materials and/or organic materials that form the seal after they are cured via an ultra-violet light. Although these types of seals typically provide adequate mechanical strength, these seals can be relatively expensive and are prone to high failure rate under a given set of conditions. Another common way for sealing an OLED display is to utilize metal welding or soldering, however, the resulting seal is typically less durable over a wide range of temperatures due to the substantial differences between the coefficients of thermal expansions of the glass plates and the metal within the OLED display. More recent approaches have included the use of a glass frit that is deposited onto at least one of a first and second substrate plate included in the OLED display, the specific of this approach being detailed in U.S. Patent No. 6,998,776, entitled GLASS PACKAGE THAT IS HERMETICALLY SEALED WITH A FRIT AND METHOD OF FABRICATION, as assigned to Corning Incorporated, and which is incorporated by reference in its entirety herein. Specifically, this process includes depositing the frit on at least one of the substrates and heating the frit via irradiation source (e.g., laser, infrared light, and the like), thereby forming a hermetic seal that connects the first substrate plate to the second substrate plate and also protects the associated OLEDs. This frit may be doped with at least one transition metal and/or a coefficient of thermal expansion lowering filler such that when the irradiation source heats the frit, it softens and forms a bond, thereby enabling the frit to melt and form the hermetic seal while avoiding thermal damage to the OLEDs.

Many of today's applications for OLED displays require a reduction of overall size and thickness of the incorporating device, thereby requiring a minimized thickness of the OLED display itself. As a result, minimizing the spacing between the associated substrates is desired. However, certain drawbacks have been associated with the relatively close spacing (e.g., 15 microns or less) of the inside surfaces of the substrates with respect to one another and have given rise to certain problems, one of which is the formation of visible Newton rings in the resultant display. These Newton rings, caused by interference of white light between the relatively close reflective surfaces of the substrates of the OLED display, render the overall display useless, or requires the displays to be used within applications wherein high picture quality is not required.

An OLED display that provides the necessary hermetic seal and protection of the OLED components, while simultaneously producing or eliminating image distortion caused by the formation of Newton rings due to the required relative close spacing of the substrates associated with the OLED display is desired.

### SUMMARY OF THE INVENTION

The present invention relates to a top emission, organic light-emitting diode display that comprises an organic layer, an anode layer, and a cathode layer, wherein at least a portion of the organic layer is sandwiched between the anode layer and the cathode layer. The display further comprises a first substrate having an inner surface and an outer surface, and a second substrate having an inner surface and an outer surface, wherein the organic layer, the anode layer and the cathode layer are sandwiched between the first substrate and the second substrate, at least a select one of the first substrate and the second substrate including a pocket formed in the inner surface thereof and having a depth such that distance between at least a portion of the inner surface of the first substrate and at least a portion of the inner surface of the second substrate is greater than or equal to 60 microns, and wherein the display is adapted to operate as a top-emitting display. The invention further relates to having a hermetic seal between the first and second substrates, thereby hermetically sealing the organic layer, the anode layer and the cathode layer therebetween.

The present invention also includes a process for manufacturing a hermetically-sealed, top emission, organic light-emitting diode display that comprises providing an organic layer, providing an anode layer, and providing a cathode layer, wherein the organic layer is sandwiched between the anode layer and the cathode layer. The process also comprises providing a first substrate having an inner surface and an outer surface, and providing a second substrate having an inner surface and an outer surface, such that the organic layer, the anode layer and the cathode layer are sandwiched between the first and second substrate. The process further includes forming a pocket in the inner surface of at least a select one of the first substrate and the second substrate, the pocket having a depth such that a distance between at least a portion of the inner surface of the first substrate and at least a portion of the inner surface of the second substrate is greater than or equal to 60 microns when the first and second substrates are coupled to one another, and hermetically sealing the organic layer, the anode layer and the cathode layer between the first and second substrates.

The present invention further includes a glass package comprising a first glass plate having an inner surface, a second glass plate having an inner surface and a frit deposited between the inner surface of the first glass plate and the inner surface of the second glass plate, wherein the frit is heated by an irradiation source in a manner that causes the frit to melt and form a hermetic seal between the first and second glass plates that connects the first glass plate and the second glass plate such that a distance between at least a portion of the inner surface of the first glass plate and at least a portion of the inner surface of the second glass plate is greater than or equal to 60 microns when the first and second glass plates are connected to one another.

The present invention still further includes a process for manufacturing a hermetically-sealed, top emission, organic light-emitting diode display comprising providing an organic layer, providing an anode layer, and providing a cathode layer, wherein at least a portion of the organic layer is sandwiched between the anode layer and the cathode layer. The process also includes providing a first substrate having an inner surface, and providing a second substrate having an inner surface, and such that the organic layer, the anode layer and the cathode layer are sandwiched between the first substrate and the second substrate. The process further includes depositing a frit between the inner surface of the first glass plate and the inner surface of the second glass plate, and hermetically sealing the organic layer, the anode layer and the cathode layer between the first substrate and the second substrate by heating a frit to a melting point, and such that a distance between at least a portion of the inner surface of first glass plate and at least a portion of the inner surface of second glass plate is greater than or equal to 60 microns.

The present inventive top emission, organic light-emitting diode display and related method provides the necessary hermetic seal to protect the associated OLED components, while simultaneously providing the necessary spacing between the included substrates to reduce or eliminate optical distortions, such as Newton rings in the display. The display and related method result in reduced manufacturing costs, provide a durable display capable of a long operating life, and are particularly well adapted for the proposed use.

### BRIEF DESCRIPTION OF THE DRAWINGS

Fig. 1 is an exploded perspective view illustrating the basic components of a hermetically-sealed OLED display embodying the present invention;
Fig. 2 is a top plan view of the OLED display;
Fig. 3 is a flow chart illustrating the steps of an embodiment for manufacturing the hermetically-sealed OLED display;
Fig. 4 is a cross-sectional side view of a first embodiment of the OLED display taken along the line IV-IV, Fig. 2;
Fig. 5 is a cross-sectional side view of a second embodiment of the OLED display;
Fig. 6 is a perspective and schematic view of a system employed to manufacture the OLED display;
Fig. 7 is a cross-sectional side view of a third embodiment of the OLED display; and
Fig. 8 is a flow chart illustrating the steps of a method for manufacturing the third embodiment of the hermetically-sealed OLED.

### DETAILED DESCRIPTION OF THE PREFERRED EMBODIMENTS

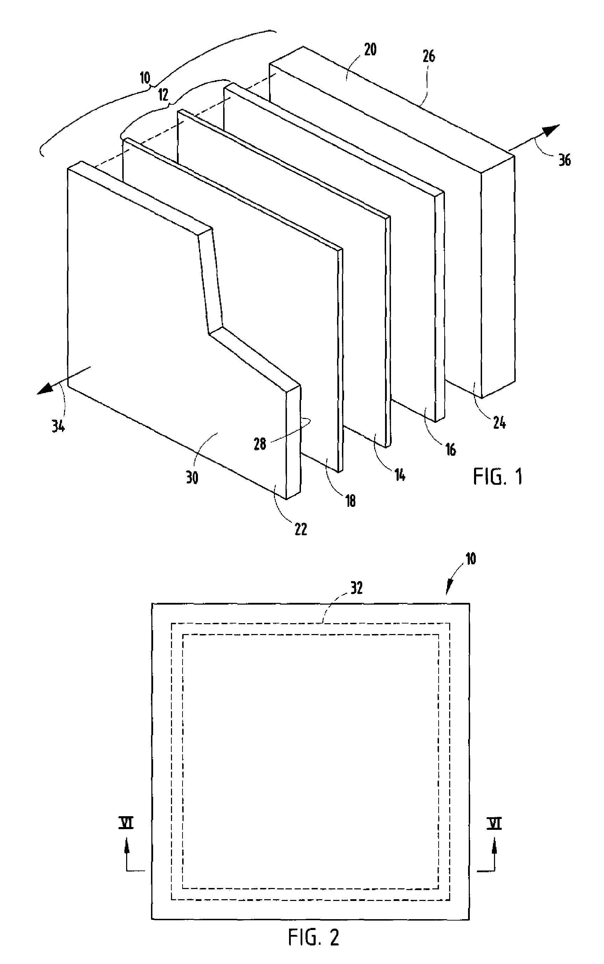

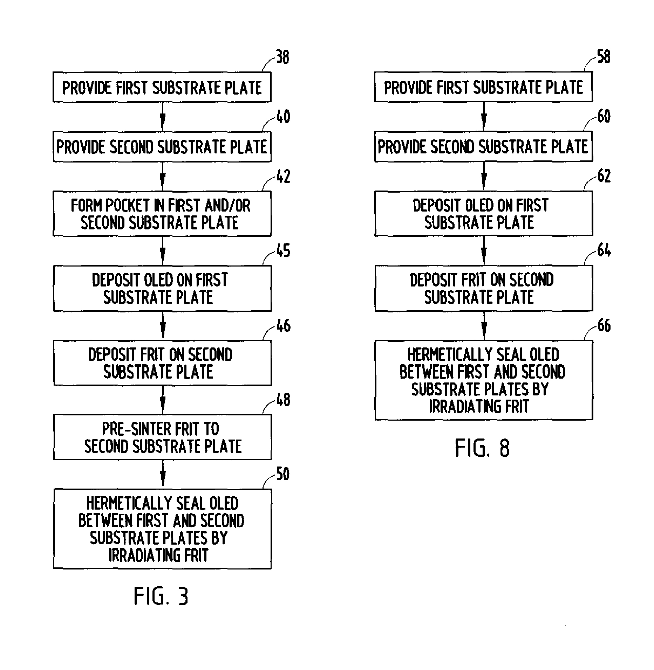

For purposes of description herein, the terms "upper," "lower," "right," "left," "rear," "front," "vertical," "horizontal," and derivatives thereof shall relate to the invention as oriented in Figs. 1 and 3. However, it is to be understood that the invention may assume various alternative orientations and step sequences, except where expressly specified to the contrary. It is also to be understood that the specific devices and processes illustrated in the attached drawings, and described in the following specification are exemplary embodiments of the inventive concepts defined in the appended claims. Hence, specific dimensions and other physical characteristics relating to the embodiments disclosed herein are not to be considered as limiting, unless the claims expressly state otherwise.

Reference numeral 10 (Fig. 1) generally designates a top emission, organic light-emitting diode display embodying the present invention. The display 10 comprises an organic light-emitting diode 12 (OLED) configured in a manner as is well known in the art and including an organic layer or stack 14 sandwiched between a pair of electrodes including an anode layer 16 and a cathode layer 18. Although the OLED 12 of the illustrated example includes a single organic layer 14, a single anode layer 16, and a single cathode layer 18, other multiple layered OLEDs as are known in the art may be utilized within the display 10. A first substrate 20 includes an inner surface 24 and an outer surface 26, while a second substrate 22 includes an inner surface 28 and an outer surface 30. As illustrated, the display 10 is a top-emitting display, wherein the light output from the OLED 12 is emitted in a direction as represented by directional arrow 34, but may also include top-bottom emitting displays, wherein the light output from the OLED 12 is emitted in the direction 34, as well as in an opposite direction as represented by directional arrow 36. The light is emitted at blue (approximately 460 nm), green (approximately 530 nm), and red (approximately 600 nm) parts of the visible spectrum with line width of 20 to 30 nm.

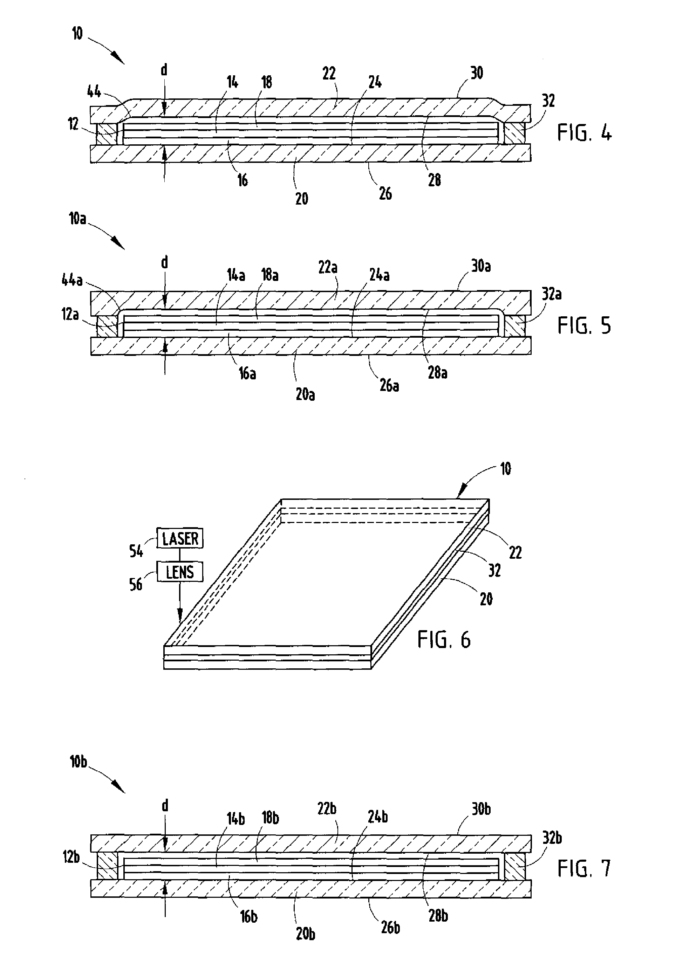

A preferred method for manufacturing the hermetically-sealed OLED display 10 is illustrated in Fig. 3 and includes a first step 38 of providing the first substrate plates 20 and a second step 40 of providing the second substrate plate 22. In a preferred embodiment, the first and second substrate plates 20, 22 are transparent glass plates such as those sold by Corning Incorporated under the brand name of Eagle 2000™ glass. Alternatively, the first and second substrates 20, 22 may be manufactured out of other suitable materials. A third step 42 includes forming a pocket 44 (Fig. 4) within the cover or second substrate 22. In the illustrated example, the pocket 44 is roll formed into the second substrate 22 by heating the substrate 22 and applying a physical roller, a vacuum and/or a pressure to the inner surface 28 and/or the outer surface 30 of the second substrate 22 in a manner as generally known in the art. The roll-forming process is described in detail in U.S. Patent No. 5,885,315 entitled METHOD FOR FORMING GLASS SHEETS and assigned to Corning Incorporated, which is incorporated by reference herein in its entirety. It is noted that the outer surface 30 of the second substrate 22 is non-planar subsequent to the deformation thereof. In the illustrated example, the pocket 44 within the second substrate 22 is formed such that a distance between the inner surface 28 of the second substrate 22 and the inner surface 24 of the first substrate 20 is sufficient so as to reduce or eliminate the formation of Newton rings within the display 10. Preferably, the distance d is greater than or equal to 60 µm, and more preferably is greater than or equal to 80 µm.

Alternatively, the pocket 44a (Fig. 5) is etched into the inner surface 28a of the second substrate 22a, thereby providing a planer outer surface 30a to the second substrate 22a. Since the display 10a is similar to the display 10, similar parts appearing in Fig. 4 ad Fig,. 5, respectively, are represented by the same, corresponding reference numeral, except for the suffix "a" in the numerals of the latter. It is contemplated that the etching process would include applying a photo-resistant material and using lithography or a similar method, placing the glass sheet into a HF/water or HF/HCl/water solution for a sufficient amount of time to remove the required amount of exposed glass. Subsequent to the acid etching, the photo-resistant material is removed. It is noted that other suitable glass etching processes may also be utilized.

At step 45, the OLED 12 and other required circuitry are deposited onto the inner surface 24 of the first substrate 20. Step 46 includes depositing the frit 32 along the edges of the second substrate 22, as best illustrated in Fig. 2. As an example, the frit 32 is placed approximately 1 mm away from the free edges of the second substrate 22. In the present embodiment, the frit 32 comprises a low temperature glass frit that contains one or more absorbing ions chosen from a group including iron, copper, vanadium and neodymium. The frit 32 can also be doped with a filler (e.g., inversion filler, additive filler) which lowers the co-efficient of thermal expansion of the frit 32 so that the coefficient of thermal expansion of the frit matches or substantially matches the coefficient of thermal expansions of the first and second substrates 20, 22. In an optional step 48, the frit 32 may be pre-sintered to the second substrate 22 by heating the frit 32 so that it becomes attached to the second substrate 22.

The step 50 includes heating the frit 32 (Fig. 6) by an irradiation source (e.g., laser 54 and a focusing lens 56, or an infrared lamp (not shown), and the like) in a manner so that the frit 32 forms an hermetic seal that connects and bonds the first substrate 20 and the second substrate 22. The hermetic seal between the first substrate and the second substrate 22 protects the OLED 12 by preventing oxygen and moisture in the ambient environment from entering into the OLED display 10.

The reference numeral 10b (Fig. 7) generally designates yet another embodiment of the hermetically-sealed OLED display manufactured from a method illustrated by the flow chart of Fig. 8. As the OLED display 10b is similar to the OLED display 10, similar parts appearing in Figs. 4 and Figs. 7, respectively, are represented by the same, corresponding reference numeral, except for the suffix "b" in the numerals of the latter. Steps 58, 60 include providing the first substrate 20b and the second substrate 22b, while step 62 includes depositing the OLED 12a onto the first substrate 20b, each similar to that previously described. Step 64 includes depositing a frit 32a along the edges of the second substrate 22a, in a manner similar to that described above. In the instant example, the frit 32a comprises a strong laser absorbing material, and a relatively weak laser radiation absorbing material. The distance d between the inner surface 24b of the first substrate 30b and the inner surface 28b of the second substrate 22b is adjusted by controlling the amount and composition of the material of frit 32b, and can be optimized so as to reduce or eliminate the formation of Newton rings in the display 10b. Preferably, the distance d is greater than or equal to 60 µm and is more preferably greater than or equal to 80 µm. The layer of frit material that highly absorbs the radiation is described in U.S. Patent Nos. 6,998,776, as previously incorporated herein. It is noted that the strong laser radiation absorbing material and the relatively weak laser radiation absorbing material that comprise the frit 32a may be deposited as separate layers. Compositions utilized for the frit 32a that exhibit relatively high radiation absorption characteristics include:

| Composition | SiO₂ | B₂O₃ | Al₂O₃ | Fe₂O₃ | CuO | V₂O₅ | Li₂O | TiO₂ | CTE(10^{-7°}C to 400°C Heating |
|---|---|---|---|---|---|---|---|---|---|
| Mole % | 64 | 20.5 | 4 | 1.5 | 8 | 0.5 | 1 | 0.5 | 37 |

Examples of the transparent frit material include:

| Wt% | Example 1 | Example 2 |
|---|---|---|
| SiO₂% | 76.97 | 78.77 |
| Na₂O% | 5.27 | 0.00 |
| K₂O% | 0.00 | 2.39 |
| B₂O₃% | 15.32 | 18.30 |
| Al₂O₃% | 1.89 | 0.00 |
| Cl-% | 0.50 | 0.50 |
| TiO₂% | 0.02 | 0.02 |
| SO₃% | 0.01 | 0.00 |
| Fe₂O₃% | 0.02 | 0.02 |
| MgO% | 0.00 | 0.00 |
| CTE | 33 | 28 |
| Softening Point | 818°C | 820°C |

The present inventive top emission, organic light-emitting diode display and related method provides the necessary hermetic seal to protect the associated OLED components, while simultaneously providing the necessary spacing between the included substrates to reduce or eliminate optical distortions, such as Newton rings in the display. The display and related method result in reduced manufacturing costs, provide a durable display capable of a long operating life, and are particularly well adapted for the proposed use.

It will become apparent to those skilled in the art that various modifications to the preferred embodiment of the invention as described herein can be made without departing from the spirit or scope of the invention as defined in the appended claims. Thus, it is intended that the present invention covers the modifications and variations of this invention provided they come within the scope of the appended claims and the equivalents thereto.

## Claims

1. A top emission, organic light emitting diode display comprising:
an organic layer;
an anode layer;
a cathode layer, wherein at least a portion of the organic layer is sandwiched between the anode layer and the cathode layer;
a first substrate having an inner surface and an outer surface; and
a second substrate having an inner surface and an outer surface, wherein the organic layer, the anode layer and the cathode layer are sandwiched between the first substrate and the second substrate, at least a select one of the first substrate and the second substrate including a pocket formed in the inner surface thereof and having a depth such that a distance between at least a portion of the inner surface of the first substrate and at least a portion of the inner surface of the second substrate is greater than or equal to 60 microns, and wherein the display is adapted to operate as a top emitting display.

2. The top emission, organic light emitting diode display of claim 1, wherein the distance between at least a portion of the inner surface of the first substrate and at least a portion of the inner surface of the second substrate is greater than or equal to 80 microns.

3. The top emission, organic light emitting diode display of claim 1, wherein the organic layer, the anode layer and the cathode layer are hermetically sealed between the first and second substrates.

4. The top emission, organic light emitting diode display of claim 1, wherein the anode layer is proximate the first substrate, the cathode layer is proximate the second substrate, and wherein the second substrate includes the pocket.

5. The top emission, organic light emitting diode display of claim 4, wherein the first substrate is translucent.

6. The top emission, organic light emitting diode display of claim 1, wherein the outer surface of at least one of the substrates is non-planar.

7. A process for manufacturing a hermetically sealed, top emission, organic light emitting diode display comprising:
providing an organic layer;
providing an anode layer;
providing a cathode layer, wherein at least a portion of the organic layer is sandwiched between the anode layer and the cathode layer;
providing a first substrate having an inner surface;
providing a second substrate having an inner surface, such that the organic layer, the anode layer and the cathode layer are sandwiched between the first substrate and the second substrate;
forming a pocket in the inner surface of at least a select one of the first substrate and the second substrate, the pocket having a depth such that a distance between at least a portion of the inner surface of the first substrate and at least a portion of the inner surface of the second substrate is greater than or equal to 60 microns when the first and second substrate are coupled to one another; and
hermetically sealing the organic layer, the anode layer and the cathode layer between the first substrate and the second substrate.

8. The process of claim 7, wherein the step of forming the pocket includes forming the pocket such that the distance between at least a portion of the inner surface of the first substrate and at least a portion of the inner surface of the second substrate is greater than or equal to 80 microns when the first and second substrate are coupled to one another.

9. The process of claim 7, wherein the step of providing the first substrate includes placing the first substrate proximate the anode layer, the step of providing the second substrate includes placing the second substrate proximate the cathode layer, and wherein the step of forming the pocket includes forming the pocket in the inner surface of the second substrate.

10. The process of claim 9, wherein the step of providing the first substrate includes providing the first substrate as substantially opaque.

11. The process of claim 7, wherein the step of forming the pocket includes roll-forming at least a select one of the inner surface of the first substrate and the inner surface of the second substrate.

12. The process of claim 7, wherein the step of forming the pocket includes etching at least a select one of the inner surface of the first substrate and the inner surface of the second substrate.

13. A glass package comprising:
a first glass plate having an inner surface;
a second glass plate having an inner surface; and
a frit deposited between the inner surface of the first glass plate and the inner surface of the second glass plate, wherein the frit is heated by an irradiation source in a manner that causes the frit to soften and form a hermetic seal between the first and second glass plates and connects the first glass plate to the second glass plate such that a distance between at least a portion of the inner surface of the first glass plate and at least a portion of the inner surface of the second glass plate is greater than or equal to 60 microns when the first and second glass plates are connected to one another.

14. The glass package of claim 13, wherein the distance between at least a portion of the inner surface of the first glass plate and at least a portion of the inner surface of the second glass plate is greater than or equal to 80 microns when the first and second glass plates are connected to one another.

15. The glass package of claim 13, wherein the frit comprises a glass material.

16. The glass package of claim 13, wherein the frit comprises a first material having a first set of radiation absorption characteristics and a second material having a second set of radiation absorption characteristics that are different than the first set of radiation absorption characteristics.

17. The glass package of claim 13, further including:
an organic layer;
an anode layer; and
a cathode layer, wherein at least a portion of the organic layer is sandwiched between the anode layer and the cathode layer, and wherein the organic layer, the anode layer and the cathode layer are sandwiched between the first glass plate and the second glass plate.

18. A process for manufacturing a hermetically sealed, top emission, organic light emitting diode display comprising:
providing an organic layer;
providing an anode layer;
providing a cathode layer, wherein at least a portion of the organic layer is sandwiched between the anode layer and the cathode layer;
providing a first substrate having an inner surface;
providing a second substrate having an inner surface, and such that the organic layer, the anode layer and the cathode layer are sandwiched between the first substrate and the second substrate;
depositing a frit between the inner surface of the first glass plate and the inner surface of the second glass plate; and
hermetically sealing the organic layer, the anode layer and the cathode layer between the first substrate and the second substrate by heating the frit to a softening point, and such that a distance between at least a portion of the inner surface of the first glass plate and at least a portion of the inner surface of the second glass plate is greater than or equal to 60 microns.

19. The process of claim 18, wherein the step of depositing the frit includes depositing the frit such that the distance between at least a portion of the inner surface of the first glass plate and at least a portion of the inner surface of the second glass plate is greater than or equal to 80 microns.

20. The process of claim 18, wherein the depositing step includes providing the frit as a glass material.

21. The process of claim 18, wherein the hermetically sealing step includes heating the frit via a laser.

22. The process of claim 18, wherein the depositing step includes providing the frit as a first material having a first set of radiation absorption characteristics and a second material having a second set of radiation absorption characteristics that are different than the first set of radiation absorption characteristics.
